Europäisches Patentamt

European Patent Office

Office européen des brevets

(11) Publication number: **0 064 614**
**B1**

# EUROPEAN PATENT SPECIFICATION

(45) Date of publication of patent specification: **16.09.87**

(51) Int. Cl.⁴: **H 01 L 29/08**

(21) Application number: **82103228.1**

(22) Date of filing: **16.04.82**

(54) Improved emitter structure for semiconductor devices.

(30) Priority: **30.04.81 JP 65951/81**
**30.04.81 JP 65966/81**

(43) Date of publication of application:
**17.11.82 Bulletin 82/46**

(45) Publication of the grant of the patent:
**16.09.87 Bulletin 87/38**

(84) Designated Contracting States:
**CH DE GB LI SE**

(56) References cited:
**FR-A-1 519 530**
**FR-A-2 374 743**
**FR-A-2 417 854**
**GB-A-2 026 236**

(73) Proprietor: **Kabushiki Kaisha Toshiba**
**72, Horikawa-cho Saiwai-ku**
**Kawasaki-shi Kanagawa-ken 210 (JP)**

(72) Inventor: **Makoto, Azuma**
**205 Nakakibogaoka**
**Asahi-ku Yokohama-shi (JP)**

(74) Representative: **Henkel, Feiler, Hänzel & Partner**
**Möhlstrasse 37**
**D-8000 München 80 (DE)**

# 0 064 614

## Description

The present invention relates to a gate turn-off thyristor having a semiconductor substrate of at least one layer, a base layer of a first conductivity type which is formed on said semiconductor substrate, a plurality of emitter layers of a second conductivity type which are formed on a surface of said base layer, and a semiconductor region of the second conductivity type provided in the center of said each emitter layer.

The current distribution in a semiconductor element unit is generally not uniform. The current may concentrate on the part of the element unit which allows the easiest flow of current and thus may damage the element unit. This phenomenon will be more specifically described taking as examples a gate turn-off thyristor.

A gate turn-off thyristor (to be referred to as a GTO for brevity hereinafter) is a four-layered semiconductor device, which is similar to a general thyristor in that the gate electrode is maintained at a positive potential to allow flow of a gate current and to trigger the device. The thyristor of the general type is turned off by commutating the main current through a commutation circuit. In contrast to this, the GTO is turned off by maintaining the gate electrode at a negative potential which·causes negative current flow. Since the commutation circuit required space and cost and renders the overall device complex in structure, the omission of the commutation circuit provides a considerable advantage. When the devices' characteristics are considered, the turn-off time of the GTO is significantly shorter than that of the general thyristor, thus providing another advantage.

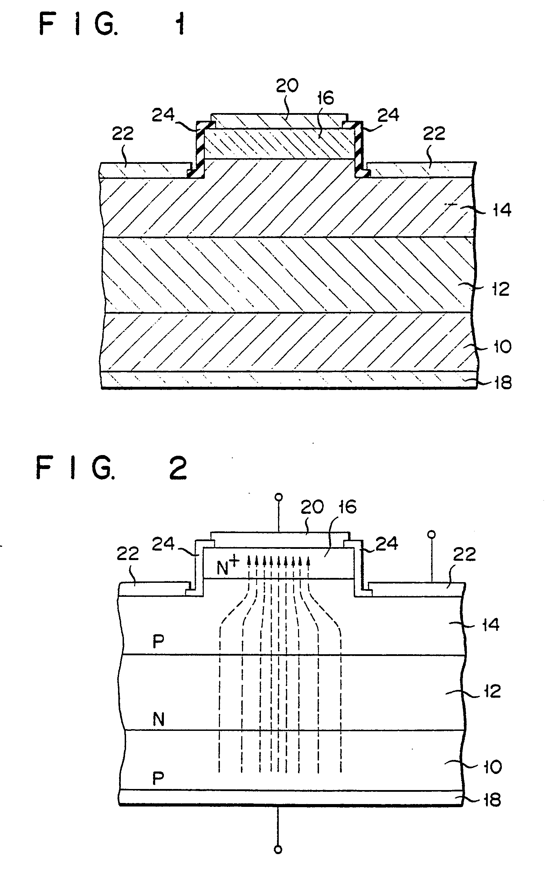

Fig. 1 is a sectional view of one element unit of a conventional GTO. Referring to Fig. 1, an n-type first base layer 12 is formed to be contiguous with a p-type first emitter layer 10 to form a p-n junction therewith. A p-type second base layer 14 is formed to be contiguous with the n-type first base layer 12 to form another p-n junction therewith. A mesa n-type second emitter layer 16 is formed to be contiguous with the p-type second base layer 14 to form still another p-n junction. An anode electrode 18, a cathode electrode 20 and a gate electrode 22 are formed as shown in Fig. 1. An insulation film 24 is formed to cover the exposed part of the p-n junction surrounding the mesa n-type second emitter layer 16. The GTO generally has a structure in which the second emitter layer 16 is divided into a plurality of parts in order to minimize the voltage drop, which is determined by the product of the gate current flowing through the second base layer 14 upon a turn-off operation, and the lateral resistance. Thus, an actual GTO would include a number of element units of the structure as shown in Fig. 1. A plurality of element units are arranged to operate in parallel to each other.

In the conventional GTO shown in Fig. 1, the current concentrates at a point which is farthest from the gate electrode 22 during a turn-off operation, that is, at the center of the second emitter layer 16. This is illustrated in Fig. 2, and will be described in more detail below. When a gate turn-off signal is applied to the gate electrode 22, that part of the second emitter layer 16 which is immediately adjacent to the gate electrode 22 is rendered nonconductive first. Thus, the current is suppressed toward the center of the second emitter layer 16. As the turn-off operation proceeds and the nonconductive region expands, the current density increases near the center of the second emitter layer 16. When the conductive region is sufficiently decreased and restoring of the current becomes impossible, the GTO turns off one-dimensionally.

However, when the gate current flowing to the gate electrode decreases to the minimum value required to turn off the GTO during the turn-off operation, the GTO cannot complete the turn-off operation and will be damaged by the excessive thermal loss.

Conventional methods for preventing the current concentration at the second emitter layer 16 during the turn-off operation includes a method for adopting a second emitter layer 16 composed of a plurality of segments of a smaller width, and a method for increasing the impurity concentration of the second base layer 14 to thereby reduce the lateral resistance of the second base layer and to allow flow of the gate current which is sufficient to complete the turn-off operation. Furthermore, the gate-cathode voltage is increased during the turn-off operation to increase the drift electric field of the second base layer 14 so that the turn-off operation is facilitated. Although these methods alleviate the current concentration phenomenon to some extent, they fail to provide the optimal solution to the problem. This is attributable to the following fact. Although the anode current may be increased in correspondence with the increase in the gate current, the extent to which the gate current may be increased is limited due to the intrinsic impedance of the second base layer 14 and the gate-cathode junction reverse breakdown voltage.

Document FR—A—1,519,530 discloses a semiconductor device and especially a power transistor having a lightly-doped resistive layer which is provided in a ring-like emitter region. This ring-like emitter region has a sheet resistance of 0.5 to 2 $\Omega/\square$ whereas the sheet resistance of the resistive layer ranges between 10 and 100 $\Omega/\square$, i.e. the ratio between the impurity concentration of the emitter region and the resistive layer amounts at most about 200.

Furthermore, prior art document GB—A—2,026,236 discloses also a power transistor in which the center region of an $N^+$-doped emitter region is P-doped like a base region, and the impurity concentration of the outer region is the same as that of the base region.

It is an object of the present invention to provide a gate turn-off thyristor which incorporates a ballast

2

# 0 064 614

function to make the current distribution uniform, and in which the current concentration may be reduced and local thermal runaway may be prevented.

The object may be achieved by a gate turn-off thyristor having a semiconductor substrate of at least one layer, a base layer of a first conductivity type which is formed on said semiconductor substrate, a plurality of emitter layers of a second conductivity type which are formed on a surface of said base layer, and a semiconductor region of the second conductivity type provided in the center of said each emitter layer, said gate turn-off thyristor being characterized in that said semiconductor region forms a current flow suppressing region which has an impurity concentration of at the most $10^{15}/cm^3$ such that a depletion zone spreads throughout the entirety of said semiconductor region when no bias voltage is applied thereto.

The present invention provides a region which defines a depletion layer under a no bias condition in each emitter layer. Therefore, the current in the emitter layer necessarily disperses, so that the current distribution becomes uniform and the local thermal runaway can be prevented.

According to another aspect of the present invention, a low impurity concentration region of a conductivity type the same as that of the emitter layer is formed at the center of the emitter layer, which is contiguous with the cathode electrode. Then, the depletion layer expands mainly into the low impurity concentration region because of the built-in voltage of the p-n junction formed by the base layer and the lower impurity concentration region inside the emitter layer. As a consequence, the carrier injection into the base layer from the low impurity concentration region is suppressed. The current in the emitter layer necessarily disperses and the threshold value for the breakdown due to current concentration increases.

By way of example and to make the description clearer, reference is made to the accompanying drawings, in which:

Fig. 1 is a partial sectional view of one element unit of a conventional gate turn-off thyristor;

Fig. 2 is a view showing the current concentration in the element unit shown in Fig. 1;

Fig. 3 is a partial sectional view showing one element unit of a gate turn-off thyristor according to an embodiment of the present invention;

Fig. 4 is a view showing the pattern of an n⁻-type layer 26 of the element unit shown in Fig. 3; and

Fig. 5 is a view showing the dispersion of the current in the element unit shown in Fig. 3.

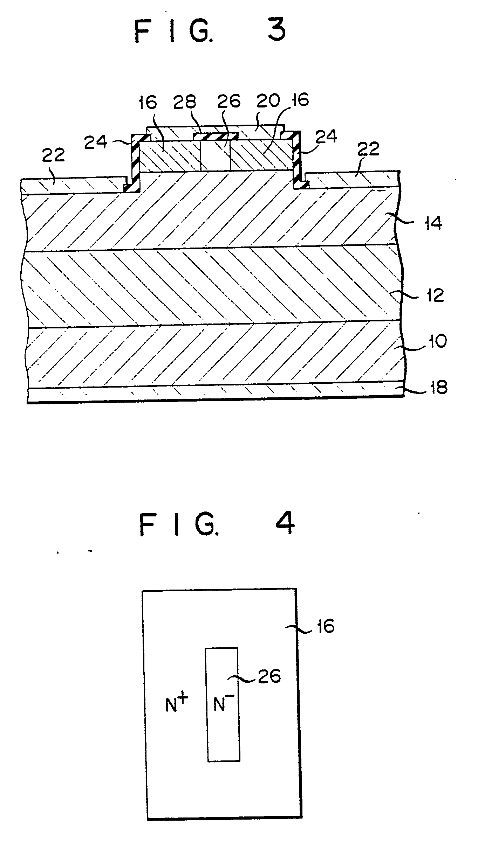

Fig. 3 shows the structure, in section, of one element unit of a gate turn-off thyristor (to be referred to as a GTO for brevity hereinafter) according to an embodiment of the present invention. The same reference numerals in Fig. 3 denote the same parts as in Fig. 1, and the detailed description thereof will be omitted. The element unit shown in Fig. 3 differs from that shown in Fig. 1 in that a low impurity concentration layer of the same conductivity type as that of the second emitter layer 16, that is, an n⁻-type layer 26 is formed in the second emitter layer 16. In this embodiment, an insulation film 28 covers the n⁻-type layer 26, and the cathode electrode 20 covers the insulation film 28. The n⁻-type layer 26 is formed in the center of the second emitter layer 16 an equal distance from the periphery of the second emitter layer 16, as seen from the pattern of Fig. 4.

The effects of the embodiment of the present invention will now be described. The GTO of the embodiment is characterized in that the n⁻-type layer 26 forms a region to completely cut off the current in the second emitter layer 16, so that the local current concentration, which occurs during the turn-off operation, may be minimized. The impurity concentration of the second base layer 14 in the vicinity of the second emitter layer 16 is generally about $10^{17}$ to $10^{18}$ cm⁻³. Therefore, if the impurity concentration of the n⁻-type layer 26 is sufficiently lower than this value, the p-n junction formed by the second base layer 14 and the n⁻-type layer 26 may be approximated by a step junction. The built-in voltage of the step junction may be easily determined according to "Physics and Technology of Semiconductor Devices" by A. S. Groove, John Wiley and Sons, Inc. Thus, the buil-in voltage $\phi T$ may be expressed by equation (1) below:

$$\phi T = (KT/q)\ln[(NA \cdot ND)/ni^2] \tag{1}$$

where K is the Boltzmann constant, T is the junction temperature, q is the electron charge, NA is the acceptor concentration of the second base layer 14, ND is the donor concentration of the n⁻-type layer 26, and ni is the intrinsic concentration. The width W of the depletion layer extending into the n⁻-type layer 26 under zero bias conditions may be expressed by equation (2) below:

$$W = \sqrt{2\varepsilon s/qND \cdot \phi T} \tag{2}$$

where εs is the dielectric constant. Using relations (1) and (2) above, the impurity concentration ND of the n⁻-type layer 26 and the width W of the depletion layer extending therein may be determined.

When the impurity concentration ND is varied under the conditions of NA = $10^{17}$ cm⁻³ and NA = $10^{18}$ cm⁻³, the built-in voltages $\phi T$ and the widths W may be obtained in case of silicon as shown in Table 1 below:

TABLE 1

| NA (cm$^{-3}$) | ND (cm$^{-3}$) | $\phi$T (V) | W ($\mu$m) |
|---|---|---|---|
| 1×10$^{17}$ | 1×10$^{15}$ | 0.691 | 0.96 |
| | 1×10$^{14}$ | 0.632 | 2.90 |
| | 1×10$^{13}$ | 0.572 | 8.72 |
| 1×10$^{18}$ | 1×10$^{15}$ | 0.751 | 1.00 |
| | 1×10$^{14}$ | 0.691 | 3.03 |
| | 1×10$^{13}$ | 0.632 | 9.16 |

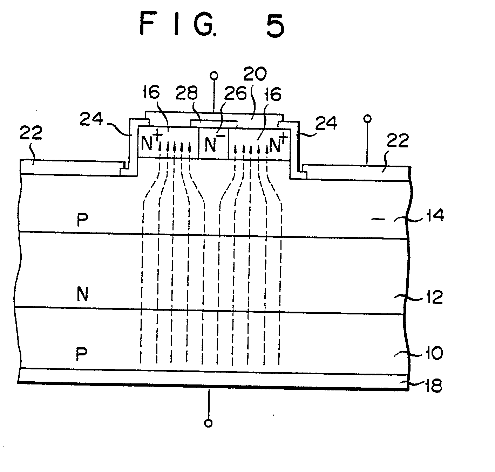

As may be seen from the table above, the lower the impurity concentration ND, the greater the increase in the width W and the greater the increase in the current cut-off capacity. When the impurity concentration is 1×10$^{15}$ cm$^{-3}$ or more, the width becomes 1 $\mu$m or less, extremely reducing the effects of the present invention. Fig. 5 shows the dispersion of the concentrated current according to this embodiment.

The GTO of the embodiment may be manufactured by the procedure to be described below. A semiconductor wafer for the first base layer 12 has a specific resistivity of 10 to 300 $\Omega \cdot$ cm, has a thickness of 0.2 to 1.2 mm, and contains an n-type impurity such as phosphorus. Although the specific resistivity and the thickness of the semiconductor wafer may be selected within the relatively wider ranges as given above, they must be appropriately selected according to the off-state voltage rating of the GTO. The off-state voltage rating obtainable with the impurity concentration and the width in the ranges as given above is within the range of 300 to 6,000 V. A p-type impurity such as gallium or boron is diffused from both major surfaces of the semiconductor wafer to form a first emitter layer 10 and a second base layer 14 having a surface impurity concentration of 10$^{17}$ to 10$^{19}$ cm$^{-3}$ and a thickness of 30 to 80 $\mu$m. A three-layered pnp structure is thus obtained. Next, an n$^{-}$-type epitaxial layer of an impurity concentration of 10$^{15}$ cm$^{-3}$ or less and a thickness of 2 to 30 $\mu$m is formed on the second base layer 14. After depositing a masking material of n conductivity type such as a thermal oxide film on each surface of the wafer, a contact hole is formed in correspondence with the high impurity concentration emitter part by lithography. An n-type impurity such as POCl$_3$ or PH$_3$ is diffused through the contact hole to form a second emitter layer 16.

After selectively forming a contact hole in the part of the second emitter layer 20 corresponding to the gate electrode by photolithography, the epitaxial layer is removed by etching so that the underlying part of the second base layer 14 may be exposed. The surface part of the n$^{-}$-type layer 26 exposing the second base layer 14 is covered by an insulation film 28. The effects of the present invention may be achieved even if this step is omitted. Thereafter, an insulation film for passivation is formed on the exposed surface of the p-n junction consisting of an n-type emitter and a p-type base. Then, the cathode, gate and anode electrodes are formed according to methods well known in the art.

The concrete data of the embodiment as described above will now be given. The semiconductor wafer has a specific resistivity of 25 $\Omega \cdot$ cm and a thickness of 250 $\mu$m. The p-type impurity doped layer has a surface impurity concentration of 6×10$^{17}$ cm$^{-3}$ and a thickness of 45 $\mu$m. The second emitter layer has a surface impurity concentration of 5×10$^{20}$ cm$^{-3}$ and a thickness of 6 $\mu$m. The n$^{-}$-type epitaxial layer has an average impurity concentration of 2×10$^{14}$ cm$^{-3}$ and a thickness of 5 $\mu$m. The width of the depletion layer extending into the epitaxial layer is approximately 5 $\mu$m. It was found that the GTO having the epitaxial layer as described above at the center, can control a current having a value of 1.8 to 2.0 times the value of the current that is controllable with the GTO of conventional structure.

In the embodiment as described above, the n$^{-}$-type layer 26 forms a region which becomes a depletion layer under a no bias condition so as to suppress the current concentration at the second emitter layer 16.

**Claims**

1. A gate turn-off thyristor having a semiconductor substrate of at least one layer (10, 12), a base layer (14) of a first conductivity type which is formed on said semiconductor substrate (10, 12), a plurality of emitter layers (16) of a second conductivity type which are formed on a surface of said base layer (14), and a semiconductor region (26) of the second conductivity type provided in the center of said each emitter layer (16), characterized in that said semiconductor region (26) forms a current flow suppressing region (26) which has an impurity concentration of at the most 10$^{15}$/cm$^3$ such that a depletion zone spreads throughout the entirety of said semiconductor region (26) when no bias voltage is applied thereto.

2. A gate turn-off thyristor according to claim 1, characterized in that said base layer (14) is formed on another base layer (12) of said second conductivity type formed on another emitter layer (10) of said first conductivity type.

4

3. A gate turn-off thyristor according to claim 1, characterized in that said base layer is formed on said semiconductor substrate including a collector layer of said second conductivity type.

4. A gate turn-off thyristor according to anyone of claims 1 to 3, characterized in that said semiconductor region (26,) is positioned in an equal distance from the periphery of said emitter layer.

5. A gate turn-off thyristor according to claim 1, characterized in that an insulation layer (28) is formed on said semiconductor region (26) to cover said semiconductor region (26), for preventing said semiconductor region (26) from being applied with a bias voltage and for causing said semiconductor region (26) to become depleted throughout the operation mode of said thyristor, thereby suppressing the concentration of emitter currents.

6. A gate turn-off thyristor according to claim 5, characterized in that said base layer (14) is of a p-conductivity type while said emitter layers (16) and said current flow suppressing region (26) are of an n-conductivity type.

7. A gate turn-off thyristor according to claim 6, characterized in that said emitter layers (16) are electrically connected to one another.

### Patentansprüche

1. Abschalt- oder GTO-Thyristor mit einem Halbleiter-Substrat aus mindestens einer Schicht (10, 12), einer auf dem Halbleiter-Substrat (10, 12) ausgebildeten Basisschicht (14) eines ersten Leitfähigkeitstyps, mehreren auf der Basisschicht (14) ausgebildeten Emitterschichten (16) eines zweiten Leitfähigkeitstyps und einer im Zentrum jeder Emitterschicht (16) vorgesehenen Halbleiterzone (26) des zweiten Leitfähigkeitstyps, dadurch gekennzeichnet, daß die Halbleiterzone (26) eine Stromfluß-Unterdrückungszone (26) bildet, die eine Fremdatomkonzentration von höchstens $10^{15}/cm^3$ aufweist, so daß sich eine Verarmungszone über die gesamte Halbleiterzone (26) ausbreitet, wenn an diese keine Vorspannung angelegt ist.

2. Abschalt-Thyristor nach Anspruch 1, dadurch gekennzeichnet, daß die Basisschicht (14) auf einer anderen, den zweiten Leitfähigkeitstyp aufweisenden Basisschicht (12) ausgebildet ist, die (ihrerseits) auf einer anderen Emitterschicht (10) des ersten Leitfähigkeitstyps ausgebildet ist.

3. Abschalt-Thyristor nach Anspruch 1, dadurch gekennzeichnet, daß die Basisschicht auf dem Halbleiter-Substrat mit einer Kollektorschicht des zweiten Leitfähigkeitstyps ausgebildet ist.

4. Abschalt-Thyristor nach einem der Ansprüche 1 bis 3, dadurch gekennzeichnet, daß die Halbleiterzone (26) jeweils in einem gleich großen Abstand vom Umfang der Emitterschicht angeordnet ist.

5. Abschalt-Thyristor nach Anspruch 1, dadurch gekennzeichnet, daß auf der Halbleiterzone (26) eine letztere bedeckende Isolierschicht (28) ausgebildet ist, um die Anlegung einer Vorspannung an die Halbleiterzone (26) zu verhindern und die Halbleiterzone (26) im gesamten Betriebsmodus des Thyristors zu verarmen und damit die Konzentration von Emitterströmen zu unterdrücken.

6. Abschalt-Thyristor nach Anspruch 5, dadurch gekennzeichnet, daß die Basisschicht (14) einen p-Leitfähigkeitstyp aufweist, während die Emitterschichten (16) und die Stromfluß-Unterdrückungszone (26) jeweils einen n-Leitfähigkeitstyp aufweisen.

7. Abschalt-Thyristor nach Anspruch 6, dadurch gekennzeichnet, daß die Emitterschichten (16) elektrisch miteinander verbunden sind.

### Revehdications

1. Un thyristor de coupure à porte comportant un substrat semiconducteur d'au moins une couche (10, 12), une couche de base (14) d'un premier type de conductivité qui est formée sur ledit substrat semiconducteur (10, 12), une pluralité de couches d'émetteur (16) d'un second type de conductivité qui sont formées sur une surface de ladite couche de base (14), et une région semiconductrice (26) du second type de conductivité prévue au centre de chacune desdites couches d'émetteur (16), caractérisé en ce que ladite région semiconductrice (26) forme une région (26) de suppression d'écoulement de courant qui présente une concentration d'impuretés d'au plus $10^{15}/cm^3$, de manière qu'une zone d'appauvrissement s'étale sur la totalité de ladite région semiconductrice (26) quand aucune tension de polarisation n'est appliquée à celle-ci.

2. Un thyristor de coupure à porte selon la revendication 1, caractérisé en ce que ladite couche de base (14) est formée sur une autre couche de base (12) dudit second type de conductivité formée sur une autre couche d'émetteur (10) dudit premier type de conductivité.

3. Un thyristor de coupure à porte selon la revendication 1, caractérisé en ce que ladite couche de base est formée sur ledit substrat semiconducteur comportant une couche de collecteur dudit second type de conductivité.

4. Un thyristor de coupure à porte selon l'une quelconque des revendications 1 à 3, caractérisé en ce que ladite région semiconductrice (26) est placée à une égale distance à partir de la périphérie de ladite couche d'émetteur.

5. Un thyristor de coupure à porte selon la revendication 1, caractérisé en ce qu'une couche d'isolation (28) est formée sur ladite région semiconductrice (26) pour recouvrir ladite région semiconductrice (26) et empêcher ladite région semiconductrice (26) de recevoir une tension de polarisation et permettre

**0 064 614**

l'appauvrissement de ladite région semiconductrice (26) tout au long du fonctionnement dudit thyristor, de manière à supprimer la concentration des courants d'émetteur.

6. Un thyristor de coupure à porte selon la revendication 5, caractérisé en ce que ladite couche de base (14) est d'un type de conductivité p tandis que lesdites couches d'émetteur (16) et ladite région (26) de suppression d'écoulement de courant sont d'un type de conductivité n.

7. Un thyristor de coupure à porte selon la revendication 6, caractérisé en ce que lesdites couches d'émetteur (16) sont électriquement reliées l'une à l'autre.

6

# F I G. 1

# F I G. 2

# F I G. 3

# F I G. 4

# F I G. 5